(19) Europäisches Patentamt
European Patent Office
Office européen des brevets

(11) **EP 4 462 505 A1**

(12) **EUROPEAN PATENT APPLICATION**
published in accordance with Art. 153(4) EPC

(43) Date of publication:
**13.11.2024 Bulletin 2024/46**

(21) Application number: **23839988.5**

(22) Date of filing: **13.07.2023**

(51) International Patent Classification (IPC):
*H01M 4/38* (2006.01)          *H01M 4/48* (2010.01)
*H01M 4/134* (2010.01)        *H01M 4/1395* (2010.01)
*H01M 4/62* (2006.01)          *H01M 4/04* (2006.01)
*H01M 10/052* (2010.01)      *C01B 33/113* (2006.01)
*C01B 33/18* (2006.01)

(52) Cooperative Patent Classification (CPC):
**C01B 33/113; C01B 33/18; H01M 4/04;**
**H01M 4/134; H01M 4/1395; H01M 4/38;**
**H01M 4/48; H01M 4/62; H01M 10/052;** Y02E 60/10

(86) International application number:
**PCT/KR2023/010017**

(87) International publication number:
**WO 2024/014897 (18.01.2024 Gazette 2024/03)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:  **13.07.2022  KR 20220086337**
**12.07.2023  KR 20230090551**

(71) Applicant: **LG Energy Solution, Ltd.**
**Seoul 07335 (KR)**

(72) Inventors:
• **KIM, Dohyeun**
**Daejeon 34122 (KR)**
• **KIM, Donghyuk**
**Daejeon 34122 (KR)**
• **LEE, Yong Ju**
**Daejeon 34122 (KR)**
• **JUN, Hyunmin**
**Daejeon 34122 (KR)**

(74) Representative: **Hoffmann Eitle**
**Patent- und Rechtsanwälte PartmbB**
**Arabellastraße 30**
**81925 München (DE)**

(54) **ANODE ACTIVE MATERIAL, METHOD FOR MANUFACTURING ANODE ACTIVE MATERIAL, ANODE COMPOSITION, ANODE FOR LITHIUM SECONDARY BATTERY, INCLUDING SAME, AND LITHIUM SECONDARY BATTERY INCLUDING ANODE**

(57)    The present application relates to a negative electrode active material, a method for manufacturing a negative electrode active material, a negative electrode composition, a negative electrode for a lithium secondary battery including the same, and a lithium secondary battery including a negative electrode.

[Figure 1]

EP 4 462 505 A1

**Description**

[Technical Field]

This application claims priority to and the benefit of Korean Patent Application No. 10-2022-0086337 filed in the Korean Intellectual Property Office on July 13, 2022, the entire contents of which are incorporated herein by reference.
The present application relates to a negative electrode active material, a method for manufacturing a negative electrode active material, a negative electrode composition, a negative electrode for a lithium secondary battery including the same, and a lithium secondary battery including a negative electrode.

[Background Art]

Due to the rapid increase in the use of fossil fuels, the demand for the use of alternative energy or clean energy is increasing, and as part thereof, the fields that are being studied most actively are the fields of power generation and power storage using an electrochemical reaction.
At present, a secondary battery is a representative example of an electrochemical device that utilizes such electrochemical energy, and the range of use thereof tends to be gradually expanding.
Along with the technology development and the increase in demand for mobile devices, the demand for secondary batteries as an energy source is sharply increasing. Among such secondary batteries, lithium secondary batteries having high energy density and voltage, long cycle life, and low self-discharging rate have been commercialized and widely used. In addition, research is being actively conducted on a method for manufacturing a high-density electrode having a higher energy density per unit volume as an electrode for such a high-capacity lithium secondary battery.
In general, a secondary battery includes a positive electrode, a negative electrode, an electrolyte, and a separator. The negative electrode includes a negative electrode active material for intercalating and deintercalating lithium ions to and from the positive electrode, and silicon-based particles having a high discharge capacity may be used as the negative electrode active material.
In particular, according to the demand for high density energy batteries in recent years, research is being actively conducted on a method for increasing a capacity by using together a silicon-based compound such as Si/C and SiOx having a capacity 10 times or higher than that of a graphite-based material, as a negative electrode active material. However, as compared with graphite that is typically used, a silicon-based compound that is a high-capacity material has a large capacity but undergoes rapid volume expansion during charging, thereby disconnecting a conductive path to degrade battery characteristics.
Accordingly, in order to address a problem occurring when the silicon-based compound is used as the negative electrode active material, a measure for controlling a driving potential, a measure for suppressing the volume expansion itself such as a method of further coating a thin film on an active material layer additionally and a method of controlling a particle diameter of a silicon-based compound, or various measures for preventing a conductive path from being disconnected have been discussed. However, the above measures may rather deteriorate the performance of a battery, and thus, the application thereof is limited, so that there is still a limitation in commercializing the manufacturing of a negative electrode battery having a high content of a silicon-based compound.
Therefore, there is a need for conducting researches on a silicon-based active material itself capable of preventing a conductive path from being damaged due to volume expansion of a silicon-based compound, even when the silicon-based active material is used as a negative electrode active material in order to improve capacity performance.

Prior Art Document

Japanese Patent Application Publication No. 2009-080971

[Detailed Description of the Invention]

[Technical Problem]

When fabricating a silicon-based active material by a chemical processing method rather than a conventional grinding processing method, it was found through research that the average particle diameter (D50) and crystal grains of the silicon-based active material can be controlled within certain ranges. Regarding this, it was confirmed that, as the crystal grains are controlled within the certain range, the reaction occurs uniformly and the stress applied to the silicon-based active material is reduced during the intercalating/deintercalating reaction of lithium.
The present application relates to a negative electrode active material, a method for manufacturing a negative electrode active material, a negative electrode composition, a negative electrode for a lithium secondary battery including the same, and a lithium secondary battery including a negative electrode capable of addressing the above-described problems.

[Technical Solution]

An exemplary embodiment of the present specification provides a negative electrode active material including a silicon-based active material whose crystal grain size is 200 nm or less, wherein the silicon-based active material has an average particle diameter (D50) of 1 um or greater and 9 um or less, and wherein the silicon-based active material includes one or more selected from the group consisting of SiOx (x=0) and SiOx (0<x<2), and includes 70 parts by weight or more of SiOx (x=0) on the basis of 100 parts by weight of the silicon-based active material.

Another exemplary embodiment provides a method for manufacturing a negative electrode active material including: depositing a silicon-based active material on a substrate by chemically reacting a silane gas; and obtaining a silicon-based active material deposited on the substrate, wherein the silicon-based active material has a crystal grain size of 200 nm or less, and wherein the silicon-based active material has an average particle diameter (D50) of 1 um or greater and 9 um or less.

Still another exemplary embodiment provides a negative electrode composition including: the negative electrode active material according to the present application; a negative electrode conductive material; and a negative electrode binder.

Yet another exemplary embodiment provides a negative electrode for a lithium secondary battery including: a negative electrode current collector layer; and a negative electrode active material layer provided on one surface or both surfaces of the negative electrode current collector layer, wherein the negative electrode active material layer includes the negative electrode composition according to the present application or a cured product thereof.

Finally, there is provided a lithium secondary battery including a positive electrode; the negative electrode for a lithium secondary battery according to the present application; a separator provided between the positive electrode and the negative electrode; and an electrolyte.

[Advantageous Effects]

Unlike the conventional grinding processing method, the negative electrode active material according to an exemplary embodiment of the present invention is produced by controlling a reaction condition of a chemical method for reacting a silane gas with an acid, and accordingly, the average particle diameter (D50) and the crystal grain size satisfy the certain ranges.

The negative electrode active material of the present invention includes one or more selected from the group consisting of SiOx (x=0) and SiOx (0<x<2) as a silicon-based active material, and includes 70 parts by weight or more of the SiOx (x=0) on the basis of 100 parts by weight of the silicon-based active material, i.e., has a pure Si active material, and addresses the problem of volume expansion due to charging and discharging, which is a problem caused when using the silicon-based active material, by controlling the average particle diameter (D50) and the crystal grain size within the certain ranges.

In particular, the negative electrode active material according to the present application is characterized by controlling the average particle diameter (D50) and crystal grain size of the silicon-based active material. In general, when a silicon-based active material having a large average particle diameter is used, resistance to movement of lithium ions in pores in an electrode decreases. However, as the average particle diameter increases, lithium ions cannot penetrate into the particles, resulting in a non-uniform reaction of lithium in the active material, whereby life characteristics are deteriorated. To improve this, if an active material with a small average particle diameter (D50) of a silicon-based active material is simply applied, the reaction occurs uniformly throughout the particle inner region, but it is difficult to secure a lithium ion path in the electrode, resulting in increased resistance and reduced long-term life performance.

In the present application, the above problems are recognized, and the negative electrode active material has such features that the resistance to movement of lithium ions in the electrode is not large and the reaction within the particle can occur uniformly by controlling the average particle diameter (D50) of the silicon-based active material within the above range. At the same time, the crystal grain size of the silicon-based particle is controlled as described above so that crystal grain boundaries are widely distributed, whereby when intercalating lithium ions, lithium ions are more uniformly distributed to reduce stress, which is generated during the intercalating of lithium ions into silicon particles, thereby mitigating breakage of the particles and further improving the life stability of the negative electrode.

[Brief Description of Drawings]

FIG. 1 is an enlarged view of a silicon-based active material according to an exemplary embodiment of the present application.

FIG. 2 is a view showing a manufacturing process of a silicon active material according to Example 1 of the present application.

FIG. 3 is a view showing a manufacturing process of a silicon active material according to Comparative Example 1 of the present application.

FIG. 4 is a view showing a laminated structure of a negative electrode for a lithium secondary battery according to an exemplary embodiment of the present application.

FIG. 5 is a view showing a laminated structure of a lithium secondary battery according to an exemplary embodiment of the present application.

FIG. 6 is a view showing a method of calculating a crystal grain size.

<Explanation of Reference Numerals and Symbols>

1: Silicon-based active material
2: crystal structure
10: Negative electrode current collector layer
20: negative electrode active material layer
30: separator
40: positive electrode active material layer
50: positive electrode current collector layer
100: negative electrode for lithium secondary battery
200: positive electrode for lithium secondary battery
A: grinding process through physical force
B: chemical reaction process after silane gasification

[Best Mode]

Before describing the present invention, some terms are first defined.

When one part "includes", "comprises" or "has" one constituent element in the present specification, unless otherwise specifically described, this does not mean that another constituent element is excluded, but means that another constituent element may be further included.

In the present specification, 'p to q' means a range of 'p or more and q or less'.

In this specification, the "specific surface area" is measured by the BET method, and specifically, is calculated from a nitrogen gas adsorption amount at a liquid nitrogen temperature (77K) by using BELSORP-mino II available from BEL Japan, Inc. That is, in the present application, the BET specific surface area may refer to the specific surface area measured by the above measurement method.

In the present specification, "Dn" refers to a particle size distribution, and refers to a particle diameter at the n% point in the cumulative distribution of the number of particles according to the particle diameter. That is, D50 is a particle diameter (average particle diameter) at the 50% point in the cumulative distribution of the number of particles according to the particle diameter, D90 is a particle diameter at the 90% point in the cumulative distribution of the number of particles according to the particle diameter, and D10 is a particle diameter at the 10% point in the cumulative distribution of the number of particles according to the particle diameter. Meanwhile, the average particle diameter may be measured using a laser diffraction method. Specifically, after powder to be measured is dispersed in a dispersion medium, the resultant dispersion is introduced into a commercially available laser diffraction particle size measurement apparatus (for example, Microtrac S3500) in which a difference in a diffraction pattern according to the particle size is measured, when a laser beam passes through particles, and then a particle size distribution is calculated.

In an exemplary embodiment of the present application, the particle size or particle diameter may mean an average diameter or representative diameter of each grain constituting the metal powder.

In the present specification, the description "a polymer includes a certain monomer as a monomer unit" means that the monomer participates in a polymerization reaction and is included as a repeating unit in the polymer. In the present specification, when a polymer includes a monomer, this is interpreted as the same as that the polymer includes a monomer as a monomer unit.

In the present specification, it is understood that the term 'polymer' is used in a broad sense including a copolymer unless otherwise specified as 'a homopolymer'.

In the present specification, a weight-average molecular weight (Mw) and a number-average molecular weight (Mn) are polystyrene converted molecular weights measured by gel permeation chromatography (GPC) while employing, as a standard material, a monodispersed polystyrene polymer (standard sample) having various degrees of polymerization commercially available for measuring a molecular weight.

In the present specification, a molecular weight refers to a weight-average molecular weight unless particularly described otherwise.

Hereinafter, embodiments of the present invention will be described in detail with reference to the drawings so that one skilled in the art can readily implement the present invention. However, the present invention may be embodied in various different forms, and is not limited to the following descriptions.

An exemplary embodiment of the present specification provides a negative electrode active material including a silicon-based active material whose crystal grain size is 200 nm or less, wherein the silicon-based active material has an average particle diameter (D50) of 1 um or greater and 9 um or less, and wherein the silicon-based active material includes one or more selected from the group consisting of SiOx (x=0) and SiOx (0<x<2), and includes 70 parts by weight or more of SiOx (x=0) on the basis of 100 parts by weight of the silicon-based active material.

The negative electrode active material of the present invention includes one or more selected from the group consisting of SiOx (x=0) and SiOx (0<x<2) as a silicon-based active material, and includes 70 parts by weight or more of the SiOx (x=0) on the basis of 100 parts by weight of the silicon-based active material, i.e., has a pure Si active material, and addresses the problem of volume expansion due to charging and discharging, which is a problem caused when using the silicon-based active material, by controlling the average particle diameter (D50) and the crystal grain size within the certain ranges.

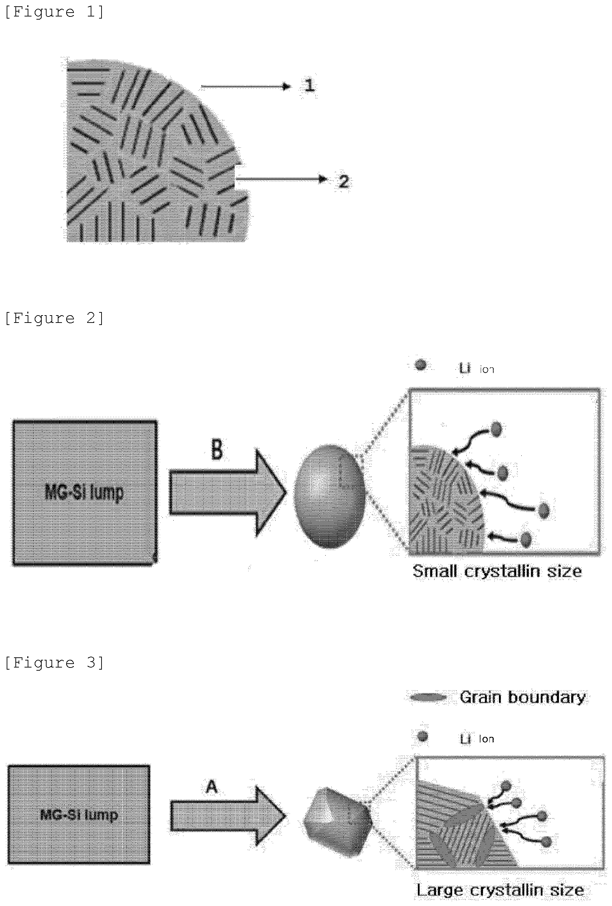

FIG. 1 is an enlarged view of a silicon-based active material according to an exemplary embodiment of the present application. Specifically, the silicon-based active material 1 is composed of a plurality of crystal structures 2, and in this case, it can be confirmed that the crystal structure has a crystal grain distribution of 1 nm or greater and 200 nm or less. In addition, a space between crystal structures may be defined as a crystal grain boundary. Also, in general, the crystal structure can be expressed as crystal grains.

In an exemplary embodiment of the present application, the silicon-based active material may include one or more selected from the group consisting of SiOx (x=0) and SiOx (0<x<2), and may include the SiOx (x=0) in an amount of 70 parts by weight or more on the basis of 100 parts by weight of the silicon-based active material.

In an exemplary embodiment of the present application, the silicon-based active material includes SiOx (x=0), and includes 70 parts by weight or more of SiOx (x=0) on the basis of 100 parts by weight of the silicon-based active material.

In another exemplary embodiment, SiOx (x=0) may be included in amount of 70 parts by weight or more, preferably 80 parts by weight or more, and more preferably 90 parts by weight or more, and 100 parts by weight or less, preferably 99 parts by weight or less, and more preferably 95 parts by weight or less on the basis of 100 parts by weight of the silicon-based active material.

In an exemplary embodiment of the present application, pure silicon (Si) particles may be particularly used as the silicon-based active material. The use of pure silicon (Si) particles as the silicon-based active material may mean that, on the basis of 100 parts by weight of the total silicon-based active material as described above, pure Si particles (SiOx (x=0)) not bonded to other particles or elements are included within the above range.

In an exemplary embodiment of the present application, the silicon-based active material may be formed of silicon-based particles having 100 parts by weight of SiOx (x=0) on the basis of 100 parts by weight of the silicon-based active material.

According to an exemplary embodiment, the crystal grain size of the SiOx (x=0) may be 200 nm or less.

In an exemplary embodiment of the present application, the silicon-based active material may include a metal impurity, and in this case, the impurity is metal that may be generally included in the silicon-based active material, and specifically, a content thereof may be 0.1 part by weight or less on the basis of 100 parts by weight of the silicon-based active material.

The capacity of the silicon-based active material is significantly higher than that of a graphite-based active material that is typically used, so that there have been more attempts to apply the same. However, the volume expansion rate of the silicon-based active material during charging/discharging is high, so that only a small amount thereof is mixed and used with a graphite-based active material.

Therefore, in the present invention, only the silicon-based active material is used as a negative electrode active material in order to improve capacity performance, and at the same time, in order to address the problems as described above, rather than controlling the composition of the conductive material and the binder, the average particle diameter (D50) and crystal grain size of the silicon-based active material itself are controlled to solve the existing problems.

In an exemplary embodiment of the present application, the crystal grain size of the silicon-based active material may be 200 nm or less.

In another exemplary embodiment, the crystal grain size of the silicon-based active material may be 200 nm or less, preferably 130 nm or less, more preferably 110 nm or less, still more preferably 100 nm or less, specifically 95 nm or less, and more specifically 91 nm or less. The crystal grain size of the silicon-based active material may have a range of 1 nm or greater, preferably 3 nm or greater.

The silicon-based active material has the crystal grain size described above, and the crystal grain size of the silicon-based active material may be controlled by changing a process condition in a manufacturing process described below. In this case, when the above range is satisfied, the crystal grain boundaries are widely distributed, and thus, the lithium ions can be uniformly intercalated during intercalating of lithium ions, thereby reducing the stress applied during intercalating of lithium ions into the silicon particles, and accordingly, mitigating breakage of the particles. As a result, it has characteristics capable of improving the lifetime stability of the negative electrode. If the crystal grain size exceeds the above range, the crystal grain boundaries within the particles are narrowly distributed, and in this case, lithium ions are non-uniformly intercalated into the particles, leading to large stress during the intercalating of ions, and accordingly, breakage of particles.

In an exemplary embodiment of the present application, there is provided the negative electrode active material in which the silicon-based active material includes a crystal structure having a crystal grain distribution of 1 nm or greater and 200 nm or less, and an area ratio of the crystal structure based on a total area of the silicon-based active material is 5% or less.

In another exemplary embodiment, the area ratio of the crystal structure based on the total area of the silicon-based active material may be 5% or less, or 3% or less, and 0.1% or greater.

That is, the silicon-based active material according to the present application has a crystal grain size of 200 nm or less, is formed so that the size of one crystal structure is small, and may satisfy the above area ratio. Accordingly, the distribution of the crystal grain boundaries may be widened, and accordingly, the above-described effects may be exhibited.

In an exemplary embodiment of the present application, there is provided the negative electrode active material in which the number of the crystal structures included in the silicon-based active material is 20 or more.

The number of the crystal structures included in the silicon-based active material may mean the number of each crystal structure in FIG. 1. That is, the silicon-based active material itself may be composed of a plurality of crystal structures, and in this case, the number of the crystal structures may be 20 or more.

In another exemplary embodiment, the number of the crystal structures included in the silicon-based active material may satisfy a range of 20 or more, 30 or more, or 35 or more, and 60 or less or 50 or less.

That is, as described above, when the crystal grain size of the silicon-based active material satisfies the above range and the number of the crystal structures satisfies the above range, the silicon-based active material itself has strength within an appropriate range. Therefore, when such a silicon-based active material is included in an electrode, flexibility can be imparted and volume expansion can be effectively suppressed.

In the present application, the crystal grain refers to a crystal particle in a metal or material, which is a collection of microscopically irregular shapes, and the crystal grain size may mean a diameter of the observed crystal grain particle. That is, in the present application, the crystal grain size means a size of a domain sharing the same crystal direction in a particle, and has a different concept from a particle size or a size of a particle diameter expressing a size of a material.

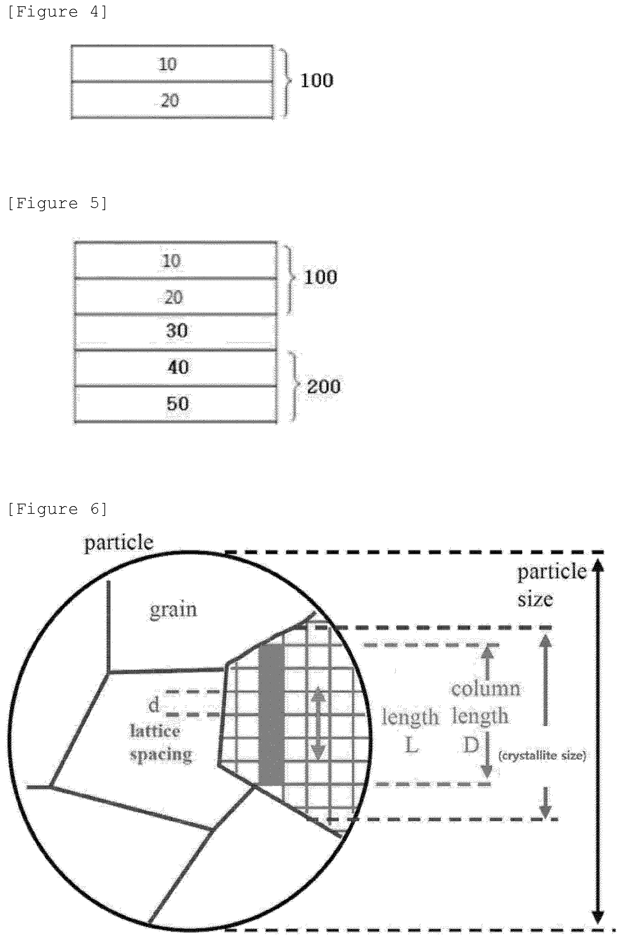

In an exemplary embodiment of the present application, the crystal grain size can be calculated as a value of full width at half maximum (FWHM) through XRD analysis. Specifically, it can be seen in FIG. 6 how to calculate the crystal grain size. In FIG. 6, the remaining values except L are measured through XRD analysis of the silicon-based active material, and the crystal grain size can be measured through the Debey-Scherrer equation showing that the FWHM and the crystal grain size are in inverse proportion. The Debey-Scherrer equation is as shown in Equation 1-1 below.

$$[\text{Equation 1-1}]$$

$$FWHM = (K\lambda)/(LCOS\theta)$$

in Equation 1-1,

L is the crystal grain size, K is a constant, $\theta$ is a Bragg angle, and $\lambda$ means a wavelength of X-ray.

In addition, the shapes of the crystal grains are diverse and can be measured in three dimensions. In general, the size of the crystal grain can be measured by a generally used circle method or diameter measurement method, but the present invention is not limited thereto.

In the diameter measurement method, the size of the crystal grain can be measured by drawing 5 to 10 parallel lines each having a length of L mm on a micrograph of a target particle, counting the number of crystal grains z on each line, and averaging them. In this case, only crystal grains that are wholly included on the line are counted, and crystal grains that are partially put (laid across) on the line are excluded. If the number of lines is P and the magnification is V, the average particle diameter can be calculated by Equation 1-2 below.

[Equation 1-2]

$$Dm = (L*P*10^3)/(zV) \ (um)$$

The circle method is a method in which a circle with a predetermined diameter is drawn on a micrograph of a target particle, and then an average area of crystal grains is calculated by the number of crystal grains in the circle and the number of crystal grains laid across the boundary line, and the average area can be calculated by Equation 1-3 below.

[Equation 1-3]

$$Fm = (Fk*10^6)/((0.67n+z)V^2) \ (um^2)$$

In Equation 1-3, Fm is an average particle area, Fk is a measurement area on the photograph, z is the number of particles in a circle, n is the number of particles laid across the circle, and V is a magnification of a microscope.

In an exemplary embodiment of the present application, the silicon-based active material may include silicon-based particles having a particle size distribution of 0.01 um or greater and 30 um or less.

The description 'the silicon-based active material includes silicon-based particles having a particle size distribution of 0.01 um or greater and 30 um or less' means including a plurality of individual silicon-based particles having a particle size within the above range, and the number of silicon-based particles included is not limited.

When the silicon-based particle is spherical, the particle size thereof can be expressed as its diameter. However, even when the silicon-based particle has a shape other than spherical, the particle size can be measured in contrast to the case of the spherical shape, and the particle size of the individual silicon-based particle can be measured by a method that is generally known in the art.

Note that the average particle diameter (D50 particle size) of the silicon-based active material of the present invention may be 1 um or greater and 9 um or less, specifically 2 um to 8 $\mu$m, and more specifically 3 um to 8 um. When the average particle diameter is within the above range, a specific surface area of the particles is within a suitable range, so that a viscosity of a negative electrode slurry is formed within an appropriate range. Accordingly, the particles constituting the negative electrode slurry are smoothly dispersed. In addition, when the size of the silicon-based active material has a value equal to or greater than the lower limit value of the range, a contact area between the silicon particles and the conductive material is excellent due to the composite made of the conductive material and the binder in the negative electrode slurry, so that a sustaining possibility of the conductive network increases, thereby increasing the capacity retention rate. In the meantime, when the average particle diameter satisfies the above range, excessively large silicon particles are excluded, so that a surface of the negative electrode is formed smooth. Accordingly, a current density non-uniformity phenomenon during charging and discharging can be prevented.

In the present application, there is provided the negative electrode active material in which the silicon-based active material has a crystal grain size of 1 nm or greater and 200 nm or less, and in which the silicon-based active material has an average particle diameter (D50) of 3 um or greater and 8 um or less.

In particular, the negative electrode active material according to the present application is characterized by controlling the average particle diameter (D50) and crystal grain size of the silicon-based active material. In general, it is known that when a silicon-based active material having a large average particle diameter is used, it is easy to secure a path for lithium ions. However, as the average particle diameter increases, the adhesion to the negative electrode current collector layer decreases, and accordingly, the life characteristic rapidly deteriorates. Accordingly, when an active material including a silicon-based active material having a small average particle diameter (D50) is simply applied, life performance is secured, but it is difficult to secure a path for lithium ions, resulting in an increase in resistance.

In the present application, the above problems are recognized, and the negative electrode active material has such features that the life characteristics can be secured by controlling the average particle diameter (D50) of the silicon-based active material within the above range, and at the same time, the crystal grain size of the silicon-based particle is controlled as described above so that crystal grain boundaries are widely distributed, whereby when intercalating lithium ions, lithium ions are more uniformly intercalated to reduce stress, which is applied during the intercalating of lithium ions into silicon particles, thereby mitigating breakage of the particles and further improving the life stability of the negative electrode.

In an exemplary embodiment of the present application, the silicon-based active material generally has a characteristic BET surface area. The BET surface area of the silicon-based active material is preferably 0.01 to 150 $m^2/g$, more preferably 0.1 to 100 $m^2/g$, particularly preferably 0.2 to 80 $m^2/g$, and most preferably 0.2 to 18 $m^2/g$. The BET surface area is measured in accordance with DIN 66131 (using nitrogen).

In an exemplary embodiment of the present application, the silicon-based active material may be present, for example, in a crystalline or amorphous form, and is preferably not porous. The silicon particles are preferably spherical or splinter-shaped particles. Alternatively, but less preferably, the silicon particles may also have a fiber structure or be present in the form of a silicon-containing film or coating.

In an exemplary embodiment of the present application, the silicon-based active material may have a non-spherical shape and its sphericity (circularity) is, for example, 0.9 or less, for example, 0.7 to 0.9, for example 0.8 to 0.9, and for example 0.85 to 0.9.

In the present application, the sphericity is determined by Equation 1-A, in which A is an area and P is a boundary line.

$$[Equation\ 1\text{-}A]$$

$$4\pi A/P^2$$

In an exemplary embodiment of the present application, there is provided a negative electrode composition including the negative electrode active material described above, a negative electrode conductive material, and a negative electrode binder.

In an exemplary embodiment of the present application, there is provided the negative electrode composition in which the negative electrode active material is included in an amount of 40 parts by weight or more on the basis of 100 parts by weight of the negative electrode composition.

In another exemplary embodiment, the negative electrode active material may be included in an amount of 40 parts by weight or more, preferably 60 parts by weight or more, more preferably 65 parts by weight or more, and further preferably 70 parts by weight or more, and 95 parts by weight or less, preferably 90 parts by weight or less, and more preferably 85 parts by weight or less, on the basis of 100 parts by weight of the negative electrode composition.

The negative electrode composition according to the present application uses the negative electrode active material satisfying the specific crystal grain size capable of controlling the volume expansion rate during charging and discharging even when the negative electrode active material having a significantly high capacity is used within the above range. Accordingly, even when the negative electrode active material is within the above range, the negative electrode composition does not degrade the performance of the negative electrode and has excellent output characteristics in charging and discharging.

In the related art, it is general to use only graphite-based compounds as the negative electrode active material. However, in recent years, as the demand for high-capacity batteries is increasing, attempts to mix and use silicon-based compounds are increasing in order to increase capacity. However, in the case of a silicon-based active material, even when the characteristics of the silicon-based active material itself are adjusted as described above, the volume may rapidly expand during the charging/discharging, thereby causing some problems of damaging the conductive path formed in the negative electrode active material layer.

Therefore, in an exemplary embodiment of the present application, the negative electrode conductive material may include one or more selected from the group consisting of a point-like conductive material, a planar conductive material and a linear conductive material.

In an exemplary embodiment of the present application, the point-like conductive material refers to a conductive material that may be used for improving conductivity of the negative electrode, has conductivity without causing a chemical change and has a point-like or spherical shape. Specifically, the point-like conductive material may be one or more species selected from the group consisting of natural graphite, artificial graphite, carbon black, acetylene black, Ketjen black, channel black, furnace black, lamp black, thermal black, conductive fiber, fluorocarbon, aluminum powder, nickel powder, zinc oxide, potassium titanate, titanium oxide, and a polyphenylene derivative, and preferably may include carbon black in terms of high conductivity and excellent dispersibility.

In an exemplary embodiment of the present application, the point-like conductive material may have a BET specific surface area of 40 $m^2$/g or greater and 70 $m^2$/g or less, preferably 45 $m^2$/g or greater and 65 $m^2$/g or less, and more preferably 50 $m^2$/g or greater and 60 $m^2$/g or less.

In an exemplary embodiment of the present application, a content of the functional group (volatile matter) of the point-like conductive material may satisfy a range of 0.01% or more and 1% or less, preferably 0.01% or more and 0.3% or less, and more preferably 0.01% or more and 0.1% or less.

In particular, when the content of the functional group of the point-like conductive material satisfies the above range, a functional group is present on a surface of the point-like conductive material, so that the point-like conductive material can be smoothly dispersed in a solvent when water is used as the solvent. In particular, in the present invention, as the specific silicon-based active material, a functional group content of the point-like conductive material can be lowered, which exhibits an excellent effect in improving dispersibility.

In an exemplary embodiment of the present application, the point-like conductive material having the content of the functional group within the range described above is included together with the silicon-based active material, and the content of the functional group can be adjusted according to a degree of heat treatment of the point-like conductive material.

In an exemplary embodiment of the present application, the particle diameter of the point-like conductive material may be 10 nm to 100 nm, preferably 20 nm to 90 nm, and more preferably 20 nm to 60 nm.

In an exemplary embodiment of the present application, the conductive material may include a planar conductive material.

The planar conductive material improves conductivity by increasing surface contact between silicon particles in the negative electrode, and at the same time, can serve to suppress disconnection of the conductive path due to the volume expansion. The planar conductive material may be expressed as a plate-like conductive material or a bulk-type conductive material.

In an exemplary embodiment of the present application, the planar conductive material may include one or more selected from the group consisting of plate-like graphite, graphene, graphene oxide, and graphite flake, and preferably may be plate-like graphite.

In an exemplary embodiment of the present application, the average particle diameter (D50) of the planar conductive material may be 2 um to 7 um, specifically 3 um to 6 $\mu$m, and more specifically 3.5 um to 5 um. When the above range is satisfied, the sufficient particle size results in easy dispersion without causing an excessive increase in viscosity of the negative electrode slurry. Therefore, the dispersion effect is excellent when dispersing using the same equipment and time.

In an exemplary embodiment of the present application, for the planar conductive material, a planar conductive material with a high specific surface area having a high BET specific surface area or a planar conductive material with a low specific surface area may be used.

In an exemplary embodiment of the present application, for the planar conductive material, a planar conductive material with a high specific surface area or a planar conductive material with a low specific surface area may be used without limitation. However, in particular, the planar conductive material according to the present application can be affected to some extent in the electrode performance by the dispersion effect, so that a planar conductive material with a low specific surface area that does not cause a problem in dispersion is used particularly preferably.

In an exemplary embodiment of the present application, the planar conductive material may have a BET specific surface area of 1 $m^2$/g or greater.

In another exemplary embodiment, the planar conductive material may have a BET specific surface area of 1 $m^2$/g or greater and 500 $m^2$/g or less, preferably 5 $m^2$/g or greater and 300 $m^2$/g or less, and more preferably 5 $m^2$/g or greater and 250 $m^2$/g or less.

For the planar conductive material of the present application, a planar conductive material with a high specific surface area or a planar conductive material with a low specific surface area may be used.

In another exemplary embodiment, the planar conductive material is a planar conductive material with a high specific surface area, and the BET specific surface area may satisfy a range of 50 $m^2$/g or greater and 500 $m^2$/g or less, preferably 80 $m^2$/g or greater and 300 $m^2$/g or less, and more preferably 100 $m^2$/g or greater and 300 $m^2$/g or less.

In another exemplary embodiment, the planar conductive material is a planar conductive material with a low specific surface area, and the BET specific surface area may satisfy a range of 1 $m^2$/g or greater and 40 $m^2$/g or less, preferably 5 $m^2$/g or greater and 30 $m^2$/g or less, and more preferably 5 $m^2$/g or greater and 25 $m^2$/g or less.

Other conductive materials may include linear conductive materials such as carbon nanotubes. The carbon nanotubes may be bundle-type carbon nanotubes. The bundle-type carbon nanotubes may include a plurality of carbon nanotube units. Specifically, the term 'bundle type' herein refers to, unless otherwise specified, a bundle or rope-shaped secondary shape in which a plurality of carbon nanotube units are aligned side by side in such an orientation that longitudinal axes of the carbon nanotube units are substantially the same, or are entangled. The carbon nanotube unit has a graphite sheet having a cylindrical shape with a nano-sized diameter, and has an sp2 bonding structure. In this case, the characteristics of a conductor or a semiconductor may be exhibited depending on the rolled angle and structure of the graphite sheet. As compared with entangled-type carbon nanotubes, the bundle-type carbon nanotubes can be more uniformly dispersed during the manufacture of the negative electrode, and can form more smoothly a conductive network in the negative electrode to improve the conductivity of the negative electrode.

In the present application, there is provided the negative electrode composition in which the negative electrode conductive material is included in an amount of 20 parts by weight or less on the basis of 100 parts by weight of the negative electrode composition.

In another exemplary embodiment, based on 100 parts by weight of the negative electrode composition, the negative electrode conductive material may be included in an amount of 20 parts by weight or less, 17 parts by weight or less, or 15 parts by weight or less, and 3 parts by weight or more, or 5 parts by weight or more.

The negative electrode conductive material according to the present application has a completely different configuration from that of a positive electrode conductive material that is applied to the positive electrode. That is, the negative electrode conductive material according to the present application serves to hold the contact between silicon-based active materials whose volume expansion of the electrode is very large due to charging and discharging, and the positive electrode conductive material serves to impart some conductivity while serving as a buffer when roll-pressed, and is completely different from the negative electrode conductive material of the present invention in terms of configuration and role.

In addition, the negative electrode conductive material according to the present application is applied to a silicon-based active material, and has a completely different configuration from that of a conductive material that is applied to a graphite-based active material. That is, since a conductive material that is used for an electrode having a graphite-based active material simply has smaller particles than the active material, the conductive material has characteristics of improving output characteristics and imparting some conductivity, and is completely different from the negative electrode conductive material that is applied together with the silicon-based active material as in the present invention, in terms of configuration and role.

In an exemplary embodiment of the present application, the planar conductive material that is used as the negative electrode conductive material described above has a different structure and role from those of the carbon-based active material that is generally used as the negative electrode active material. Specifically, the carbon-based active material that is used as the negative electrode active material may be artificial graphite or natural graphite, and refers to a material that is processed and used into a spherical or point-like shape so as to facilitate storage and release of lithium ions.

On the other hand, the planar conductive material that is used as the negative electrode conductive material is a material having a plane or plate-like shape, and may be expressed as plate-like graphite. That is, the planar conductive material is a material that is included so as to maintain a conductive path in the negative electrode active material layer, and means a material for securing a conductive path in a planar shape inside the negative electrode active material layer, rather than playing a role in storing and releasing lithium.

That is, in the present application, the use of plate-like graphite as a conductive material means that graphite is processed into a planar or plate-like shape and used as a material for securing a conductive path rather than playing a role in storing or releasing lithium. In this case, the negative electrode active material included together has high-capacity characteristics with respect to storing and releasing lithium, and serves to store and release all lithium ions transferred from the positive electrode.

On the other hand, in the present application, the use of a carbon-based active material as an active material means that the carbon-based active material is processed into a point-like or spherical shape and used as a material for storing or releasing lithium.

That is, in an exemplary embodiment of the present application, artificial graphite or natural graphite, which is a carbon-based active material, has a point-like shape, and a BET specific surface area thereof may satisfy a range of 0.1 $m^2$/g or greater and 4.5 $m^2$/g or less. In addition, plate-like graphite, which is a planar conductive material, has a planar shape, and a BET specific surface area thereof may be 5 $m^2$/g or greater.

In an exemplary embodiment of the present application, the negative electrode binder may include at least one selected from the group consisting of polyvinylidenefluoride-hexafluoropropylene copolymer (PVDF-co-HFP), polyvinylidenefluoride, polyacrylonitrile, polymethylmethacrylate, polyvinyl alcohol, carboxymethylcellulose (CMC), starch, hydroxypropylcellulose, regenerated cellulose, polyvinylpyrrolidone, tetrafluoroethylene, polyethylene, polypropylene, polyacrylic acid, ethylene-propylene-diene monomer (EPDM), sulfonated EPDM, styrene butadiene rubber (SBR), fluoro rubber, poly acrylic acid, and the above-described materials in which a hydrogen is substituted with Li, Na, Ca, etc., and may also include various copolymers thereof.

The negative electrode binder according to an exemplary embodiment of the present application serves to hold the active material and the conductive material in order to prevent distortion and structural deformation of the negative electrode structure in volume expansion and relaxation of the silicon-based active material. When such roles are satisfied, all of the general binders can be applied. Specifically, an aqueous binder may be used, and more specifically, a PAM-based binder may be used.

In an exemplary embodiment of the present application, the negative electrode binder may be included in an amount of 30 parts by weight or less, preferably 25 parts by weight or less, and more preferably 20 parts by weight or less, and 5 parts by weight or more, and 10 parts by weight or more, on the basis of 100 parts by weight of the negative electrode composition.

An exemplary embodiment of the present application provides a method for manufacturing a negative electrode active material including: depositing a silicon-based active material on a substrate by chemically reacting a silane gas; and obtaining a silicon-based active material deposited on the substrate, wherein the silicon-based active material has a crystal grain size of 200 nm or less, and wherein the silicon-based active material has an average particle diameter (D50) of 1 um or greater and 9 um or less.

According to an exemplary embodiment of the present application, the method for manufacturing a negative electrode active material may further include forming a silane gas by reacting silicon having a purity of 99% or higher with an acid. In this case, silicon having a purity of 99% or higher can be expressed as metallurgical grade Si (MG-silicon).

According to an example, the silane gas may include one or more gas selected from monosilane, dichlorosilane, and trichlorosilane, and specifically, may be a trichlorosilane gas.

In an exemplary embodiment of the present application, the depositing of a silicon-based active material on a substrate by chemically reacting a silane gas may be performed under a pressure condition of 10 Pa to 150 Pa. Due to such a low pressure, a silicon growth rate is reduced, and as a result, formation of small crystal grains can be achieved. The depositing may be performed under a temperature condition of 100°C or higher, specifically 500°C or higher, preferably 800°C or higher, more preferably 800°C to 1300°C, or 800°C to 1100°C. This is a lower temperature than the existing gas atomizing method that performs heating at 1600°C or higher in order to melt Si.

In the related art, a silicon-based active material is manufactured by pulverizing MG-silicon, which is a lump of silicon, by applying a physical force thereto, and according to this manufacture, the size of the crystal grain generally exceeds 200 nm. When simply manufacturing a silicon-based active material by the method of the related art, it is difficult to secure life stability of the negative electrode because the crystal grain size cannot be controlled.

However, in the method for manufacturing a negative electrode active material according to the present application, after silane gasification as described above, the silane gas is deposited on a substrate through a chemical reaction, making it possible to form silicon particles. Specifically, the temperature and pressure conditions in the process are modified to obtain a silicon-based active material satisfying the crystal grain size according to the present application.

In an exemplary embodiment of the present application, there is provided a negative electrode for a lithium secondary battery including: a negative electrode current collector layer; and a negative electrode active material layer including the negative electrode composition according to the present application or a cured product thereof formed on one surface or both surfaces of the negative electrode current collector layer.

FIG. 4 shows a laminated structure of a negative electrode for a lithium secondary battery according to an exemplary embodiment of the present application. Specifically, a negative electrode 100 for a lithium secondary battery can be seen which includes a negative electrode active material layer 20 on one surface of a negative electrode current collector layer 10. FIG. 4 shows that the negative electrode active material layer is formed on one surface, but the negative electrode active material layer may be formed on both surfaces of the negative electrode current collector layer.

In an exemplary embodiment of the present application, the negative electrode for a lithium secondary battery may be formed by applying and drying a negative electrode slurry including the negative electrode composition to one surface or both surfaces of the negative electrode current collector layer.

In this case, the negative electrode slurry may include the negative electrode composition described above, and a slurry solvent.

In an exemplary embodiment of the present application, a solid content of the negative electrode slurry may satisfy a range of 5% or more and 40% or less.

In another exemplary embodiment, the solid content of the negative electrode slurry may satisfy a range of 5% or more and 40% or less, preferably 7% or more and 35% or less, and more preferably 10% or more and 30% or less.

The solid content of the negative electrode slurry may mean a content of the negative electrode composition included in the negative electrode slurry, and may mean a content of the negative electrode composition on the basis of 100 parts by weight of the negative electrode slurry.

When the solid content of the negative electrode slurry satisfies the above range, the viscosity is appropriate during formation of the negative electrode active material layer, so that particle aggregation of the negative electrode composition is minimized to efficiently form the negative electrode active material layer.

In an exemplary embodiment of the present application, the slurry solvent may be used without limitation as long as it can dissolve the negative electrode composition, and specifically, water or NMP may be used.

In an exemplary embodiment of the present application, the negative electrode current collector layer generally has a thickness of 1 μm to 100 um. Such negative electrode current collector layer is not particularly limited as long as it has high conductivity without causing a chemical change in the battery. For example, copper, stainless steel, aluminum, nickel, titanium, fired carbon, copper or stainless steel each surface-treated with carbon, nickel, titanium, silver, or the like, an aluminum-cadmium alloy, or the like may be used. In addition, the negative electrode current collector layer may have microscopic irregularities formed on a surface to enhance a coupling force of the negative electrode active material, and may be used in various forms such as a film, a sheet, a foil, a net, a porous body, a foamed body, or a non-woven fabric body.

In an exemplary embodiment of the present application, there is provided the negative electrode for a lithium secondary battery in which a thickness of the negative electrode current collector layer is 1 um or greater and 100 um or less and a thickness of the negative electrode active material layer is 5 um or greater and 500 um or less.

However, the thickness may be variously modified depending on a type and use of the negative electrode used, and is not limited thereto.

In an exemplary embodiment of the present application, a porosity of the negative electrode active material layer may satisfy a range of 10% or greater and 60% or less.

In another exemplary embodiment, the porosity of the negative electrode active material layer may satisfy a range of 10% or greater and 60% or less, preferably 20% or greater and 50% or less, and more preferably 30% or greater and 45% or less.

The porosity varies depending on compositions and contents of the silicon-based active material, conductive material and binder included in the negative electrode active material layer, and in particular, satisfies the range described above when the silicon-based active material according to the present application and the conductive material are included in the specific compositions and contents, so that the electrode has appropriate ranges of electrical conductivity and resistance.

An exemplary embodiment of the present application provides a lithium secondary battery including a positive electrode; the negative electrode for a lithium secondary battery according to the present application; a separator provided between the positive electrode and the negative electrode; and an electrolyte.

FIG. 5 shows a laminated structure of a lithium secondary battery according to an exemplary embodiment of the present application. Specifically, a negative electrode 100 for a lithium secondary battery including a negative electrode active material layer 20 on one surface of a negative electrode current collector layer 10 can be seen, a positive electrode 200 for a lithium secondary battery including a positive electrode active material layer 40 on one surface of a positive electrode current collector layer 50 can be seen, and the negative electrode 100 for a lithium secondary battery and the positive electrode 200 for a lithium secondary battery are formed in a laminated structure with a separator 30 interposed therebetween.

The secondary battery according to the exemplary embodiment of the present specification may particularly include the negative electrode for a lithium secondary battery described above. Specifically, the secondary battery may include a negative electrode, a positive electrode, a separator interposed between the positive electrode and the negative electrode, and an electrolyte, and the negative electrode is the same as the negative electrode described above. Since the negative electrode has been described above, a detailed description thereof is omitted.

The positive electrode may include a positive electrode current collector and a positive electrode active material layer formed on the positive electrode current collector and including the positive electrode active material.

In the positive electrode, the positive electrode current collector is not particularly limited as long as it has conductivity without causing a chemical change in the battery. For example, stainless steel, aluminum, nickel, titanium, fired carbon, aluminum or stainless steel each surface treated with carbon, nickel, titanium, silver, or the like, or the like may be used. In addition, the positive electrode current collector may typically have a thickness of 3 to 500 um, and a surface of the current collector may be formed with microscopic irregularities to enhance adhesion of the positive electrode active material. For example, the positive electrode current collector layer may be used in various forms such as a film, a sheet, a foil, a net, a porous body, a foamed body, and a non-woven fabric body.

The positive electrode active material may be a positive electrode active material that is typically used. Specifically, the positive electrode active material may be a layered compound such as a lithium cobalt oxide ($LiCoO_2$) and a lithium nickel oxide ($LiNiO_2$), or a compound substituted with one or more transition metals; a lithium iron oxide such as $LiFe_3O_4$; a lithium manganese oxide such as chemical formula $Li_{1+c1}Mn_{2-c1}O_4$ ($0 \leq c1 \leq 0.33$), $LiMnO_2$, $LiMn_2O_2$ and $LiMnO_2$; a lithium copper oxide ($Li_2CuO_2$) ; a vanadium oxide such as $LiV_3O_8$, $V_2O_5$ and $Cu_2V_2O_7$; a Ni-site type lithium nickel oxide represented by chemical formula $LiNi_{1-c2}M_{c2}O_2$ (where M is at least one selected from the group consisting of Co, Mn, Al, Cu, Fe, Mg, B, and Ga, and satisfies $0.01 \leq c2 \leq 0.3$); a lithium manganese composite oxide represented by chemical formula $LiMn_{2-c3}M_{c3}O_2$ (where M is at least one selected from the group consisting of Co, Ni, Fe, Cr, Zn and Ta, and satisfies $0.01 \leq c3 \leq 0.1$) or $Li_2Mn_3MO_8$ (where M is at least one selected from the group consisting of Fe, Co, Ni, Cu and Zn) ; $LiMn_2O_4$ in which a part of Li of the chemical formula is substituted with an alkaline earth metal ion, or the like, but is not limited thereto. The positive electrode may be Li metal.

The positive electrode active material layer may include a positive electrode conductive material and a positive electrode binder, together with the positive electrode active material described above.

In this case, the positive electrode conductive material is used to impart conductivity to the electrode, and can be used without particular limitation as long as the positive electrode conductive material has electronic conductivity without causing a chemical change in a battery. Specific examples may include graphite such as natural graphite and artificial graphite; a carbon-based material such as carbon black, acetylene black, Ketjen black, channel black, furnace black, lamp black, thermal black and carbon fiber; metal powders or metal fibers such as copper, nickel, aluminum and silver; a conductive whisker such as zinc oxide and potassium titanate; a conductive metal oxide such as titanium oxide; or a conductive polymer such as polyphenylene derivative, or the like, and any one thereof or a mixture of two or more thereof may be used.

In addition, the positive electrode binder serves to improve bonding between particles of the positive electrode active material and adhesion between the positive electrode active material and the positive electrode current collector. Specific examples may include polyvinylidene fluoride (PVDF), vinylidene fluoride-hexafluoropropylene copolymer (PVDF-co-HFP), polyvinyl alcohol, polyacrylonitrile, carboxymethylcellulose (CMC), starch, hydroxypropylcellulose, regenerated cellulose, polyvinylpyrrolidone, tetrafluoroethylene, polyethylene, polypropylene, ethylene-propylene-diene polymer (EPDM), sulfonated-EPDM, styrene butadiene rubber (SBR), fluoro rubber, or various copolymers thereof, and the like, and any one thereof or a mixture of two or more thereof may be used.

The separator serves to separate the negative electrode and the positive electrode and to provide a movement path of lithium ions, in which any separator may be used as the separator without particular limitation as long as it is typically used in a secondary battery, and particularly, a separator having high moisture-retention ability for an electrolyte as well as a low resistance to the movement of electrolyte ions may be preferably used. Specifically, a porous polymer film, for example, a porous polymer film manufactured from a polyolefin-based polymer, such as an ethylene homopolymer, a propylene homopolymer, an ethylene/butene copolymer, an ethylene/hexene copolymer, and an ethylene/methacrylate copolymer, or a laminated structure having two or more layers thereof may be used.

In addition, a typical porous non-woven fabric, for example, a non-woven fabric formed of high melting point glass fibers, polyethylene terephthalate fibers, or the like may be used. Furthermore, a coated separator including a ceramic component or a polymer material may be used to secure heat resistance or mechanical strength, and the separator having a single layer or multilayer structure may be selectively used.

Examples of the electrolyte may include an organic liquid electrolyte, an inorganic liquid electrolyte, a solid polymer electrolyte, a gel-type polymer electrolyte, a solid inorganic electrolyte, or a molten-type inorganic electrolyte that may be used in the manufacturing of the lithium secondary battery, but are not limited thereto.

Specifically, the electrolyte may include a non-aqueous organic solvent and a metal salt.

As the non-aqueous organic solvent, for example, an aprotic organic solvent such as N-methyl-2-pyrrolidinone, propylene carbonate, ethylene carbonate, butylene carbonate, dimethyl carbonate, diethyl carbonate, gamma-butyrolactone, 1,2-dimetoxy ethane, tetrahydrofuran, 2-methyltetrahydrofuran, dimethyl sulfoxide, 1,3-dioxolane, formamide, dimethylformamide, dioxolane, acetonitrile, nitromethane, methyl formate, methyl acetate, phosphoric acid triester, trimethoxy methane, dioxolane derivative, sulfolane, methyl sulfolane, 1,3-dimethyl-2-imidazolidinone, propylene carbonate derivative, tetrahydrofuran derivative, ether, methyl propionate, or ethyl propionate may be used.

In particular, among the carbonate-based organic solvents, ethylene carbonate and propylene carbonate, which are cyclic carbonates, are high-viscosity organic solvents and can be preferably used because they have high permittivity to dissociate a lithium salt well. When the cyclic carbonate is mixed with a linear carbonate with low viscosity and low permittivity, such as dimethyl carbonate or diethyl carbonate, in a suitable ratio and used, an electrolyte having high electric conductivity may be prepared, and therefore, may be more preferably used.

A lithium salt may be used as the metal salt, and the lithium salt is a material that is readily soluble in the non-aqueous electrolyte, in which, for example, one or more species selected from the group consisting of $F^-$, $Cl^-$, $I^-$, $NO_3^-$, $N(CN)_2^-$, $BF_4^-$, $ClO_4^-$, $PF_6^-$, $(CF_3)_2PF_4^-$, $(CF_3)_3PF_3^-$, $(CF_3)_4PF_2^-$, $(CF_3)_5PF^-$, $(CF_3)_6P^-$, $CF_3SO_3^-$, $CF_3CF_2SO_3^-$, $(CF_3SO_2)_2N^-$, $(FSO_2)_2N^-$, $CF_3CF_2(CF_3)_2CO^-$, $(CF_3SO_2)_2CH^-$, $(SF_5)_3C^-$, $(CF_3SO_2)_3C^-$, $CF_3(CF_2)_7SO_3^-$, $CF_3CO_2^-$, $CH_3CO_2^-$, $SCN-$ and $(CF_3CF_2SO_2)_2N-$ may be used as an anion of the lithium salt.

One or more additives, for example, a haloalkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride, may be further included in the electrolyte for the purpose of improving life characteristics of the battery, suppressing a decrease in battery capacity, improving discharge capacity of the battery, and the like, in addition to the above-described electrolyte components.

An exemplary embodiment of the present invention provides a battery module including the secondary battery as a unit cell, and a battery pack including the same. Since the battery module and the battery pack include the secondary battery having high capacity, high-rate capability, and high cycle characteristics, the battery module and the battery pack may be used as a power source of a medium to large sized device selected from the group consisting of an electric vehicle, a hybrid electric vehicle, a plug-in hybrid electric vehicle, and a power storage system.

Hereinafter, preferred examples will be provided for better understanding of the present invention. It will be apparent to one skilled in the art that the examples are only provided to illustrate the present invention and various modifications and alterations are possible within the scope and technical spirit of the present invention. Such modifications and alterations naturally fall within the scope of claims included herein.

<Manufacture Example>

<Manufacture of Negative Electrode Active Materials in Examples 1 to 8 and Comparative Examples 2 to 7>

FIG. 2 shows a manufacturing process of a silicon active material according to Example 1 of the present application. Specifically, after silane gasification of a lump of silicon, which is MG-Si, a silicon-based active material was formed on a substrate through deposition by a chemical reaction. In this case, through process condition control (condition selection for controlling the crystal grain size in Table 1 within the ranges of the temperature condition of 800°C to 1100°C and the pressure condition of 10 Pa to 150 Pa, and control of the crystal grain size by controlling the temperature and pressure conditions), the crystal grain sizes of the silicon-based active materials of the remaining Examples 2 to 8 and Comparative Examples 2 to 7 could be controlled, and the results are shown in Table 1.

<Manufacture of Negative Electrode Active Materials of Comparative Examples 1 and 8>

FIG. 3 shows a manufacturing process of a silicon active material according to Comparative Examples 1 and 8 of the present application. Specifically, the lump of silicon, which is MG-Si, was pulverized by a physical force, and in this case, the crystal grain size of the silicon-based active material is as shown in Table 1.

[Table 1]

|  | Crystal grain size (nm) | D50 (um) |
|---|---|---|
| Example 1 | 42 | 6.21 |
| Example 2 | 53 | 6.21 |
| Example 3 | 62 | 6.21 |
| Example 4 | 91 | 6.21 |
| Example 5 | 150 | 4.52 |
| Example 6 | 200 | 5.06 |
| Example 7 | 16 | 5.17 |
| Example 8 | 1 | 3.02 |
| Comparative Example 1 | 212 | 5.76 |
| Comparative Example 2 | 42 | 10 |
| Comparative Example 3 | 150 | 10 |
| Comparative Example 4 | 200 | 10 |
| Comparative Example 5 | 42 | 0.8 |
| Comparative Example 6 | 150 | 0.8 |
| Comparative Example 7 | 200 | 0.8 |
| Comparative Example 8 | 212 | 11 |

In Table 1, the average particle diameter (D50) of the silicon-based active material could be controlled by varying the synthesis time of the silicon-based active material and the process time in a classification process. Particularly, in the classification process, the regions of large particles and small particles were removed to satisfy D50 in Table 1.

<Manufacture of Negative Electrode>

A negative electrode slurry was manufactured by adding a negative electrode active material including the silicon-based active material of Table 1, a conductive material, and polyacrylamide as a binder to distilled water as a solvent for formation of a negative electrode slurry in a weight ratio of 80:10:10 (solid concentration: 28 wt%). Specifically, the conductive material was carbon black (specific surface area: 45 m2/g, diameter: 30 to 50 nm).
As a specific mixing method, after dispersing the conductive material, the binder and water at 2500 rpm for 30 minutes with a homo mixer, the silicon-based active material was added to the dispersion, which was then dispersed at 2500 rpm for 30 minutes to fabricate a negative electrode slurry.
The negative electrode slurry was coated on a single surface of a copper current collector (thickness: 15 um) serving as a negative electrode current collector layer with a loading amount of 227 mg/50 cm$^2$, which was then roll-pressed and dried in a vacuum oven at 130°C for 10 hours to form a negative electrode active material layer (thickness: 23 um), which was prepared as a negative electrode (thickness of negative electrode: 38 um, porosity of negative electrode: 40.0%).

<Manufacture of Secondary Battery>

A positive electrode slurry was manufactured by adding LiNi$_{0.6}$Co$_{0.2}$Mn$_{0.2}$O$_2$ (average particle diameter (D50) :

15 um) as a positive electrode active material, carbon black (product name: Super C65, manufacturer: Timcal) as a conductive material, and polyvinylidene fluoride (PVdF) as a binder to N-methyl-2-pyrrolidone (NMP) as a solvent for formation of a positive electrode slurry in a weight ratio of 97:1.5:1.5 (solid concentration: 78 wt%).

The positive electrode slurry was coated on both surfaces of an aluminum current collector (thickness: 12 um) serving as a positive electrode current collector with a loading amount of 537 mg/25 cm$^2$, which was then roll-pressed and dried in a vacuum oven at 130°C for 10 hours to form a positive electrode active material layer (thickness: 65 um), whereby a positive electrode was manufactured (thickness of the positive electrode: 77 um, porosity: 26%).

A lithium secondary battery was manufactured by interposing a polyethylene separator between the positive electrode and the negative electrode of Examples and Comparative Examples and injecting an electrolyte.

The electrolyte was obtained by adding vinylene carbonate to an organic solvent, in which fluoroethylene carbonate (FEC) and diethyl carbonate (DMC) were mixed in a volume ratio of 10:90, in an amount of 3 wt.% on the basis of a total weight of the electrolyte and adding $LiPF_6$ as a lithium salt to a concentration of 1M.

<Experimental Example>

**Experimental Example 1: Cycle life data**

For the secondary batteries including the negative electrodes manufactured in the Examples and Comparative Examples, the life and capacity retention rate were evaluated using an electrochemical charging and discharging device. The in-situ cycle test was conducted on the secondary battery at 4.2-3.0V 1C/0.5C, and during the test, 0.33C/0.33C charging/discharging (4.2-3.0V) was performed every 50 cycles to measure the capacity retention rate.

life retention rate (%) ={( discharge capacity in the Nth cycle)/(discharge capacity in the first cycle)}×100

[Table 2]

|  | Crystal grain (nm) | D50 (um) | Life retention rate (%) after 200 cycles |
| --- | --- | --- | --- |
| Example 1 | 42 | 6.21 | 91 |
| Example 2 | 53 | 6.21 | 90 |
| Example 3 | 62 | 6.21 | 89 |
| Example 4 | 91 | 6.21 | 86 |
| Example 5 | 150 | 4.52 | 85 |
| Example 6 | 200 | 5.06 | 84 |
| Example 7 | 16 | 5.17 | 90 |
| Example 8 | 1 | 3.02 | 85 |
| Comparative Example 1 | 212 | 5.76 | 82 |
| Comparative Example 2 | 42 | 10 | 80 |
| Comparative Example 3 | 150 | 10 | 76 |
| Comparative Example 4 | 200 | 10 | 70 |
| Comparative Example 5 | 42 | 0.8 | 63 |
| Comparative Example 6 | 150 | 0.8 | 61 |
| Comparative Example 7 | 200 | 0.8 | 60 |
| Comparative Example 8 | 212 | 11 | 80 |

As can be seen in Table 2, when checking the capacity retention rates according to the cycles of Examples 1 to 8 and Comparative Examples 1 to 8, it could be confirmed that the capacity retention rates of Comparative Examples 1 to 8 were lower than or equal to those of the Examples. This corresponds to results that, when a silicon-based active material whose crystal grain size and average particle diameter (D50) of the silicon-based active material satisfy the ranges according to the present invention is used, the reaction can occur uniformly during the intercalating and deintercalating reaction of lithium at the time of charging/discharging, the stress applied to the silicon-based active material can be reduced to mitigate breakage of the particles, and accordingly, the life retention rate of the electrode is improved.

That is, it could be confirmed that the resistance to movement of lithium ions in the electrode is not large and the reaction within the particle can occur uniformly by controlling the average particle diameter (D50) of the silicon-based active material within the above range, and at the same time, the crystal grain size of the silicon-based particle is controlled as described above so that crystal grain boundaries are widely distributed, whereby when intercalating lithium ions, lithium ions are more uniformly distributed to reduce stress, which is generated during the intercalating of lithium ions into silicon particles, thereby mitigating breakage of the particles, and as a result, further improving the life stability of the negative electrode.

In the results of Experimental Example 1, it could be confirmed that the silicon-based active material having a particle diameter size within a certain range in a specific crystal grain was superior in life performance. When comparing the Examples and Comparative Examples 1 and 8, it can be confirmed that as the crystal grain size increases, the stress generated when intercalating lithium into the crystal grain boundary increases, resulting in breakage of the active material and a decrease in life performance.

When comparing Comparative Examples 2 to 7 and the Examples, it can be confirmed that life performance is different for a specific range of particle diameters. When the particle diameter size is large as in Comparative Examples 2 to 4, lithium cannot sufficiently penetrate into the active material, and relatively high stress is generated on the surface of the active material, resulting in breakage of the active material and a decrease in life performance. In addition, when the particle diameter is small as in Comparative Examples 5 to 7, it can be confirmed that as the resistance to movement of the lithium ions increases due to the increase in the moving path of lithium in the manufacture of the electrode, the life performance decreases.

That is, it could be confirmed that due to the effects of the crystal grain size and D50, the life performance of the silicon-based active material having the crystal grain size and particle size (D50) within the optimal ranges as in the present application was superior.

**Experimental Example 2: Cycle Resistance Increase Rate**

In the test in Experimental Example 1, the capacity retention rate was measured by charging/discharging (4.2-3.0V) at 0.33C/0.33C every 50 cycles, and then discharged at 2.5C pulse and SOC50 to measure the resistance for comparing and analyzing the resistance increase rate.

For the evaluation of the resistance increase rate measurement, data at 200 cycles was each calculated, and the results are shown in Table 3 below.

[Table 3]

| | Crystal grain (nm) | D50 (um) | Resistance increase rate (%) after 200 cycles (3.0 to 4.2 V range 1C/0.5C) |
|---|---|---|---|
| Example 1 | 42 | 6.21 | 5 |
| Example 2 | 53 | 6.21 | 7 |
| Example 3 | 62 | 6.21 | 8 |
| Example 4 | 91 | 6.21 | 10 |
| Example 5 | 150 | 4.52 | 12 |
| Example 6 | 200 | 5.06 | 16 |
| Example 7 | 16 | 5.17 | 9 |
| Example 8 | 1 | 3.02 | 14 |
| Comparative Example 1 | 212 | 5.76 | 20 |
| Comparative Example 2 | 42 | 10 | 37 |
| Comparative Example 3 | 150 | 10 | 46 |
| Comparative Example 4 | 200 | 10 | 52 |
| Comparative Example 5 | 42 | 0.8 | 75 |

(continued)

| | Crystal grain (nm) | D50 (um) | Resistance increase rate (%) after 200 cycles (3.0 to 4.2 V range 1C/0.5C) |
|---|---|---|---|
| Comparative Example 6 | 150 | 0.8 | 80 |
| Comparative Example 7 | 200 | 0.8 | 83 |
| Comparative Example 8 | 212 | 11 | 23 |

As can be seen in Table 3, it could be confirmed that the resistance increase rates of Comparative Examples 1 to 8 after 200 cycles were higher than those of the Examples.

As can be seen from the results of Experimental Example 2, in the case of Examples 1 to 8 of the present invention, it could be confirmed that the silicon-based active material having a particle diameter size within a certain range in specific crystal grains showed the lowest increase in resistance after cycling.

When comparing the Examples and Comparative Examples 1 and 8, it could be confirmed that as the crystal grain size increases, the stress generated when intercalating lithium into the crystal grain boundary increases, resulting in breakage of the active material, whereby the silicon-based active material is exposed to the electrolyte, and resultantly, a side reaction occurs, and a side reaction layer is piled up to increase the resistance.

When comparing Comparative Examples 2 to 7 and the Examples, it can be confirmed that life performance is different for a specific range of particle diameters. When the particle diameter size is large as in Comparative Examples 2 to 4, it could be confirmed that lithium could not sufficiently penetrate into the active material, and relatively high stress was generated on the surface of the active material, resulting in an increase in resistance due to the formation of a side reaction layer. In addition, when the particle diameter is small as in Comparative Examples 5 to 7, it could be confirmed that as the resistance to movement of the lithium ions increased due to the increase in the moving path of lithium in the manufacture of the electrode.

As a result, it could be confirmed that due to the effects of the crystal grain size and D50, the resistance increase rate of the silicon-based active material having the crystal grain size and particle size (D50) within the optimal ranges as in the present application was superior.

**Claims**

1.  A negative electrode active material comprising:

    a silicon-based active material whose crystal grain size is 200 nm or less,
    wherein the silicon-based active material has an average particle diameter (D50) of 1 um or greater and 9 um or less, and
    wherein the silicon-based active material includes one or more selected from the group consisting of SiOx (x=0) and/or SiOx (0<x<2), and includes 70 parts by weight or more of SiOx (x=0) on the basis of 100 parts by weight of the silicon-based active material.

2.  The negative electrode active material of claim 1, wherein a crystal grain size of the SiOx (x=0) is 200 nm or less.

3.  The negative electrode active material of claim 1, wherein the silicon-based active material comprises a crystal structure having a crystal grain distribution of 1 nm or greater and 200 nm or less.

4.  The negative electrode active material of claim 1, wherein the crystal grain size of the silicon-based active material is 1 nm or greater and 200 nm or less, and
    wherein the average particle diameter (D50) of the silicon-based active material is 3 um or greater and 8 um or less.

5.  A method for manufacturing a negative electrode active material of any one of claims 1 to 4, the method comprising:

    depositing a silicon-based active material on a substrate by chemically reacting a silane gas; and
    obtaining a silicon-based active material deposited on the substrate,
    wherein the silicon-based active material has a crystal grain size of 200 nm or less, and
    wherein the silicon-based active material has an average particle diameter (D50) of 1 um or greater and 9 um or less.

6. The method of claim 5, wherein the silane gas comprises one or more gases selected from monosilane, dichlorosilane and trichlorosilane.

7. The method of claim 5, wherein the depositing of a silicon-based active material on a substrate by chemically reacting a silane gas is performed under a pressure condition of 10 Pa to 150 Pa.

8. A negative electrode composition comprising:

   the negative electrode active material of any one of claims 1 to 4;
   a negative electrode conductive material; and
   a negative electrode binder.

9. The negative electrode composition of claim 8, wherein the negative electrode active material is included in an amount of 40 parts by weight or more on the basis of 100 parts by weight of the negative electrode composition.

10. The negative electrode composition of claim 8, wherein the negative electrode conductive material is included in an amount of 20 parts by weight or less on the basis of 100 parts by weight of the negative electrode composition.

11. A negative electrode for a lithium secondary battery comprising:

   a negative electrode current collector layer; and
   a negative electrode active material layer provided on one surface or both surfaces of the negative electrode current collector layer,
   wherein the negative active material layer comprises the negative electrode composition of claim 8 or a cured product thereof.

12. The negative electrode for a lithium secondary battery of claim 11, wherein a thickness of the negative electrode current collector layer is 1 um or greater and 100 um or less, and
   wherein a thickness of the negative electrode active material layer is 5 um or greater and 500 um or less.

13. A lithium secondary battery comprising:

   a positive electrode;
   the negative electrode for a lithium secondary battery of claim 11;
   a separator provided between the positive electrode and the negative electrode; and
   an electrolyte.

[Figure 1]

[Figure 2]

[Figure 3]

[Figure 4]

[Figure 5]

[Figure 6]

## INTERNATIONAL SEARCH REPORT

| | International application No. |
|---|---|
| | **PCT/KR2023/010017** |

**A. CLASSIFICATION OF SUBJECT MATTER**

**H01M 4/38**(2006.01)i; **H01M 4/48**(2010.01)i; **H01M 4/134**(2010.01)i; **H01M 4/1395**(2010.01)i; **H01M 4/62**(2006.01)i; **H01M 4/04**(2006.01)i; **H01M 10/052**(2010.01)i; **C01B 33/113**(2006.01)i; **C01B 33/18**(2006.01)i

According to International Patent Classification (IPC) or to both national classification and IPC

**B. FIELDS SEARCHED**

Minimum documentation searched (classification system followed by classification symbols)

H01M 4/38(2006.01); B82Y 30/00(2011.01); C01B 32/05(2017.01); C01B 32/956(2017.01); H01M 10/052(2010.01); H01M 4/134(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 리튬 이차 전지(lithium secondary battery), 음극 활물질(anode active material), 실리콘(silicon), 입경(diameter), 결정립(crystal grain), 실란(silane)

**C. DOCUMENTS CONSIDERED TO BE RELEVANT**

| Category* | Citation of document, with indication, where appropriate, of the relevant passages | Relevant to claim No. |
|---|---|---|
| X | KR 10-2017-0036637 A (LG CHEM, LTD.) 03 April 2017 (2017-04-03)<br>See claims 1, 2 and 7; and paragraphs [0089] and [0115]. | 1-4,8-13 |
| Y | | 5-7 |
| Y | KR 10-2017-0069163 A (LG CHEM, LTD.) 20 June 2017 (2017-06-20)<br>See claims 1 and 2; and paragraph [0178]. | 5-7 |
| A | KR 10-2016-0065028 A (SAMSUNG ELECTRONICS CO., LTD.) 08 June 2016 (2016-06-08)<br>See entire document | 1-13 |
| A | KR 10-2020-0080043 A (UNIST(ULSAN NATIONAL INSTITUTE OF SCIENCE AND TECHNOLOGY)) 06 July 2020 (2020-07-06)<br>See entire document | 1-13 |

☑ Further documents are listed in the continuation of Box C. ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **24 October 2023** | **24 October 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2023/010017**

| C. | DOCUMENTS CONSIDERED TO BE RELEVANT | |
|---|---|---|
| Category* | Citation of document, with indication, where appropriate, of the relevant passages | Relevant to claim No. |
| A | KR 10-2020-0132976 A (DONGGUAN KAIJIN NEW ENERGY TECHNOLOGY CORP., LTD.) 25 November 2020 (2020-11-25)<br>See entire document | 1-13 |

Form PCT/ISA/210 (second sheet) (July 2022)

**INTERNATIONAL SEARCH REPORT**
Information on patent family members

International application No.

**PCT/KR2023/010017**

| Patent document cited in search report | | | Publication date (day/month/year) | Patent family member(s) | | | Publication date (day/month/year) |
|---|---|---|---|---|---|---|---|
| KR | 10-2017-0036637 | A | 03 April 2017 | CN | 107735888 | A | 23 February 2018 |
| | | | | CN | 107735888 | B | 29 December 2020 |
| | | | | EP | 3355388 | A1 | 01 August 2018 |
| | | | | EP | 3355388 | A4 | 26 September 2018 |
| | | | | EP | 3355388 | B1 | 29 July 2020 |
| | | | | KR | 10-1971498 | B1 | 23 April 2019 |
| | | | | PL | 3355388 | T3 | 16 November 2020 |
| | | | | US | 11075369 | B2 | 27 July 2021 |
| | | | | US | 2018-0151868 | A1 | 31 May 2018 |
| | | | | US | 2021-0313557 | A1 | 07 October 2021 |
| | | | | WO | 2017-052278 | A1 | 30 March 2017 |
| KR | 10-2017-0069163 | A | 20 June 2017 | CN | 107925067 | A | 17 April 2018 |
| | | | | CN | 107925067 | B | 23 March 2021 |
| | | | | EP | 3382779 | A1 | 03 October 2018 |
| | | | | EP | 3382779 | A4 | 24 October 2018 |
| | | | | EP | 3382779 | B1 | 22 May 2019 |
| | | | | KR | 10-1977931 | B1 | 13 May 2019 |
| | | | | PL | 3382779 | T3 | 30 September 2019 |
| | | | | US | 10511048 | B2 | 17 December 2019 |
| | | | | US | 2018-0269519 | A1 | 20 September 2018 |
| | | | | WO | 2017-099523 | A1 | 15 June 2017 |
| KR | 10-2016-0065028 | A | 08 June 2016 | CN | 105655568 | A | 08 June 2016 |
| | | | | EP | 3026736 | A1 | 01 June 2016 |
| | | | | EP | 3026736 | B1 | 07 February 2018 |
| | | | | US | 2016-0156031 | A1 | 02 June 2016 |
| KR | 10-2020-0080043 | A | 06 July 2020 | KR | 10-2159693 | B1 | 24 September 2020 |
| | | | | WO | 2020-138629 | A1 | 02 July 2020 |
| KR | 10-2020-0132976 | A | 25 November 2020 | CN | 109802120 | A | 24 May 2019 |
| | | | | JP | 2021-519744 | A | 12 August 2021 |
| | | | | JP | 7068546 | B2 | 16 May 2022 |
| | | | | KR | 10-2533003 | B1 | 15 May 2023 |
| | | | | US | 2022-0048774 | A1 | 17 February 2022 |
| | | | | WO | 2020-151093 | A1 | 30 July 2020 |

**EP 4 462 505 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220086337
- JP 2009080971 A